# EUROPEAN PATENT APPLICATION

(11) **EP 0 851 723 A1**
(43) Date of publication of application: **01.07.1998**
(21) Application number: 97925309.3
(22) Date of filing: 09.06.1997
(51) Int. Cl.: H05K 3/34

(54) **METHOD FOR MOUNTING ELECTRONIC PARTS**

(30) Priority: 12.06.1996 JP 149648/96
(71) Applicant: Matsushita Electric Industrial Co., Ltd., Kadoma-shi, Osaka 571-8501 (JP)
(72) Inventor: AKIGUCHI, Takashi, Osaka-shi, Osaka 546-0035 (JP)
(74) Representative: Grünecker, Kinkeldey, Stockmair & Schwanhäusser Anwaltssozietät
(86) International application number: JP9701991
(87) International publication number: WO9748259

(57) **Abstract**

An electronic part mounting method is provided which offers highly reliable mounting quality by eliminating mounting quality instability. According to the present invention, an anisotropic conductive adhesive (5) is applied to an electrode (3) of a printed circuit board (4), which electrode is formed with copper foil, an outer lead (6) of an electronic part (1) is placed on the electrode (3) of the printed circuit board (4), and the anisotropic conductive adhesive (5) is hardened by heating and pressurizing the outer lead (6) of the electronic part (1) placed on the electrode (3) of the printed circuit board (4), by means of a tool (11) to mount the electronic part without using solder.

## Description

### Field of the Invention

The present invention relates to mounting an electronic part and more particularly to mounting an electronic part installed on a liquid-crystal panel, such as an IC part, on a printed circuit board.

### Background of the Invention

The methods disclosed in JP B59-2179 and JP A60-191228 are known as techniques for installing an IC part on a liquid-crystal panel. The method disclosed in JP A61-274394 and a method which involves soldering an outer lead of an IC part to a printed circuit board are known as techniques for mounting an IC part installed on a liquid-crystal panel on a printed circuit board.

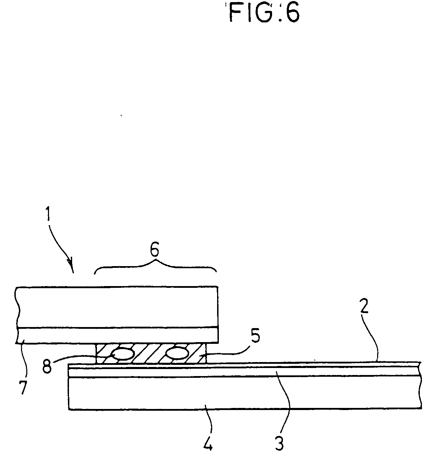

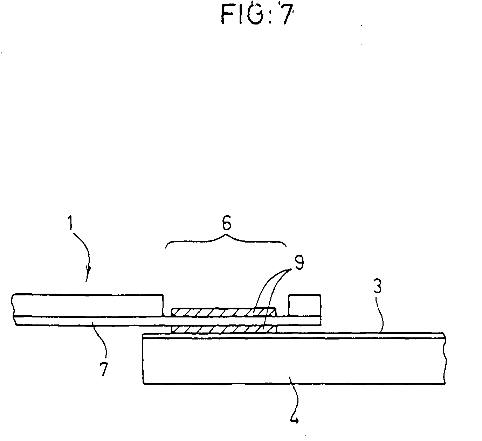

Figures 6 and 7 show conventional arrangements in which an IC part, an electronic part mounted on a liquid-crystal panel, is mounted on a printed circuit board. Figure 6 shows an arrangement in which an IC part 1 installed on a liquid-crystal panel is joined to a printed circuit board 4 having an electrode 3 given solder coating 2, with an anisotropic conductive adhesive 5 between the IC part and the printed circuit board. In Figure 6, numerals 6, 7, and 8 indicate an outer lead of the IC part 1, copper foil provided on the outer lead 6 of the IC part 1, and a conductive particle in the anisotropic conductive adhesive 5, respectively.

Figure 7 shows an arrangement in which the IC part 1 installed on a liquid-crystal panel is soldered to the printed circuit board 4, using solder 9. Elements in Figure 7 which have the same functions as in Figure 6 are given the same numerals.

Mounting the IC part 1 installed on a liquid-crystal panel on the printed circuit board 4 needs a highly reliable mounting technique to keep the liquid-crystal panel reliable. However, mounting the IC part 1 on the printed circuit board 4 having the electrode 3 given the solder coating 2, as shown in Figure 6, has caused a defective electrical connection due to oxidation or corrosion of the solder coating 2.

A method which involves soldering the outer lead 6 of the IC part 1 to the printed circuit board 4 as shown in Figure 7 has posed a problem of low mounting quality due to poor wetting of the solder 9, a broken lead, or solder bridging between leads.

### Disclosure of the Invention

It is an object of the present invention, which is made to solve the above problems, to provide an electronic part mounting method offering highly reliable mounting quality by eliminating mounting quality instability.

According to the invention set forth in Claim 1, to solve the problems, an electronic part mounting method for mounting an electronic part on a printed circuit board by joining an outer lead of the electronic part, such as an IC part bonded to a liquid-crystal panel, to the printed circuit board comprises the steps of applying an anisotropic conductive adhesive onto an electrode of the printed circuit board, which electrode is formed with copper foil, placing the outer lead of the electronic part on the electrode of the printed circuit board, and hardening the anisotropic conductive adhesive by heating and pressurizing the outer lead of the electronic part placed on the electrode of the printed circuit board, by means of a tool. Since by the method, an outer lead of an electronic part and an electrode of a printed circuit board are joined together without using solder, problems with soldering, that is, defective electrical connections due to oxidized or corroded solder and low mounting quality due to poor wetting of solder, a broken lead or bridging between leads are solved, thus eliminating mounting quality instability, so that highly reliable mounting quality is provided.

According to the invention set forth in Claim 2, a method is provided for removing antioxidant from an electrode of a printed circuit board, which electrode is formed with copper foil, and applying an anisotropic conductive adhesive directly onto the electrode of the printed circuit board. That is, the invention is characterized in that no antioxidant is applied to the electrode of the printed circuit board, which is formed with copper foil. This prevents a problem of antioxidant on copper foil being likely to interrupt electrical continuity.

According to the invention set forth in Claim 3, a tool for heating and pressurizing is provided whose pressurizing side end is semicircularly convex, the diameter of the semicircle being between 0.1 and 6.0mm. The invention, when an electronic part is joined to a printed circuit board, enables the anisotropic conductive adhesive to be easily pushed outward, since the pressurizing side end of the tool is semicircular. This, in turn, means that the portion which is semicircularly convex can more strongly press an outer lead of the electronic part against an electrode of a printed circuit board, so that the distance between the outer lead of the electronic part and the electrode of the printed circuit board is reduced, thus lowering electrical connection resistance.

According to the invention set forth in Claim 4, an outer lead of an electronic part to be heated and pressurized is provided which is formed with copper foil only. If outer lead reinforcing resin and copper foil are bonded together, a problem arises of the adhesive weakening when it is heated by the tool, so that the adhesion between the reinforcing resin and copper foil deteriorate. According to the invention, however, the above problem does not arise, thus preventing the electronic part from breaking.

According to the invention set forth in Claim 5, a tool for heating and pressurizing is provided which has a thermal conductivity of 4.0 W/m·k or more. The thermal conductivity of the tool is so high that heat can quickly be supplied to an outer lead to be heated and pressurized, thus preventing heavy expansion deformation of an electronic part due to heat.

According to the invention set forth in Claim 6, copper foil is formed on the portion of an outer lead of an electronic part to be heated and pressurized other than both ends of the outer lead, and portions on which no copper foil is provided are formed at both ends of the outer lead. The invention prevents the outer lead from breaking due to the difference in thermal expansion between a liquid-crystal panel and a printed circuit board.

### Brief Description of the Drawings

Figure 1 is a cross-sectional view of the junction between an outer lead of an IC part mounted by the electronic part mounting method according to a first embodiment of the present invention and a printed circuit board and of the neighborhood of the junction;
Figure 2 (a) is a cross-sectional view of the junction between an outer lead of an IC part mounted by the electronic part mounting method according to a second embodiment of the present invention and a printed circuit board and of the neighborhood of the junction;
Figure 2 (b) is a cross-sectional view of the junction between an outer lead of an IC part and a printed circuit board and of the neighborhood of the junction, which view is for describing the problems;
Figure 3 is a perspective view of the junction between an outer lead of an IC part mounted by the electronic part mounting method according to a third embodiment of the present invention and a printed circuit board and of the neighborhood of the junction;
Figure 4 is a cross-sectional view of the junction between an outer lead of an IC part mounted by the electronic part mounting method according to a fourth embodiment of the present invention and a printed circuit board and of the neighborhood of the junction;
Figure 5 is a plan view of an IC part mounted by the electronic part mounting method according to a sixth embodiment of the present invention;
Figure 6 is a cross-sectional view of the junction between an outer lead of an IC part mounted by a conventional electronic part mounting method and a printed circuit board and the neighborhood of the junction; and
Figure 7 is a cross-sectional view of the junction between an outer lead of an IC part mounted by a conventional electronic part mounting method and a printed circuit board and the neighborhood of the junction.

### Description of the Embodiments

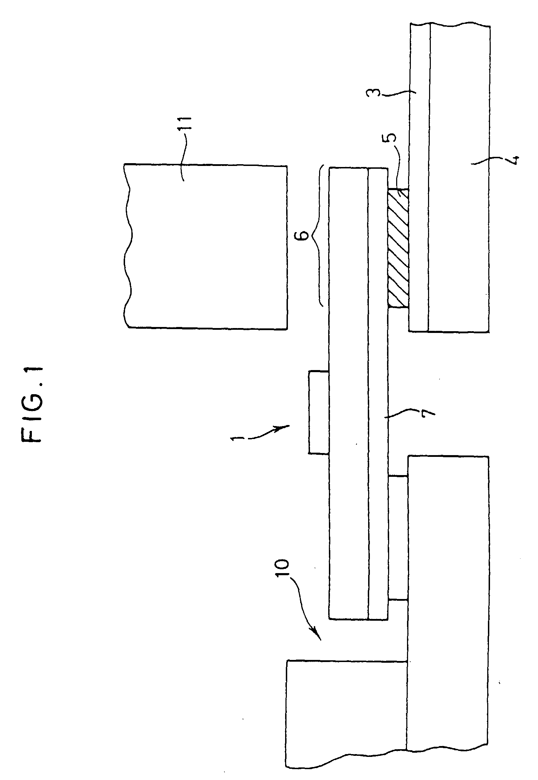

Referring now to Figures 1 through 5, embodiments of the present invention are described below.

### First Embodiment

Figure 1 is a cross-sectional view of the junction between an outer lead of an IC part mounted by the electronic part mounting method according to a first embodiment of the present invention and a printed circuit board and of the neighborhood of the junction. Elements with the same functions as conventional ones are given the same numerals, and their description is omitted.

As shown in Figure 1, the electronic part mounting method according to the first embodiment involves first applying the anisotropic conductive adhesive 5 to the electrode 3 of the printed circuit board 4, which electrode is made of copper foil, then placing the outer lead 6 of the IC part 1, that is, an electronic part bonded to a liquid-crystal panel 10 on the electrode 3 of the printed circuit board 4, and hardening the anisotropic conductive adhesive 5 by heating and pressurizing the outer lead 6, placed on the electrode 3, by means of a tool 11. Through these steps, the outer lead 6 of the IC part 1 and the electrode 3 of the printed circuit board 4 are joined together, with the anisotropic conductive adhesive 5 in between, to mount the IC part 1 on the printed circuit board 4.

Since the mounting method mounts the IC part 1 on the printed circuit board 4 without using solder, problems with soldering, that is, defective electrical connections due to oxidized or corroded solder, poor solder wetting in soldering, a broken lead, and solder bridging between leads are prevented from deteriorating mounting quality, so that highly reliable mounting quality is offered.

### Second Embodiment

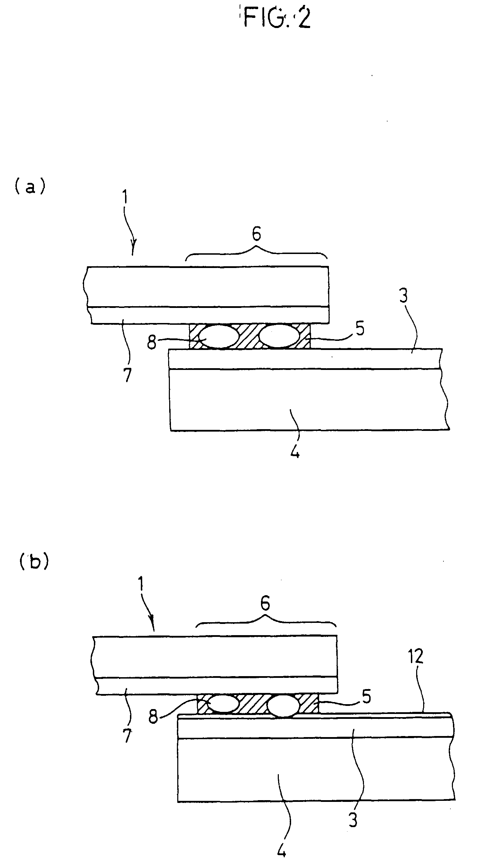

Figure 2 is a cross-sectional view of the junction between an outer lead of an IC part mounted by the electronic part mounting method according to a second embodiment of the present invention and a printed circuit board and of the neighborhood of the junction. Elements with the same functions as those of the above embodiment and conventional elements are given the same numerals, and their description is omitted.

Antioxidant on the electrode 3 of the printed circuit board 4 is wiped off beforehand using a cloth moistened with ethanol, the anisotropic conductive adhesive 5 is applied directly onto the printed circuit board 4, and the outer lead 6 of the IC part 1 and the electrode 3 of the printed circuit board 4 are joined together through the same steps as in the case of the first embodiment to mount the IC part 1 on the printed circuit board 4 with no antioxidant in between, as shown in Figure 2 (a).

In other words, if the anisotropic conductive adhesive 5 is applied to the printed circuit board 4 without wiping the antioxidant 12 off the electrode 3 of the printed circuit board 4, and the same steps as in the case of the first embodiment are used, the antioxidant 12 may block the conductive particles 8 in the anisotropic conductive adhesive 5, so that the particles do not come in contact with the electrode 3 of the printed circuit board 4, thus resulting in poor continuity.

According to an embodiment of the present invention, however, the conductive particles 8 in the anisotropic conductive adhesive 5 come in proper contact with the electrode 3 of the printed circuit board 4, thus providing good continuity.

### Third Embodiment

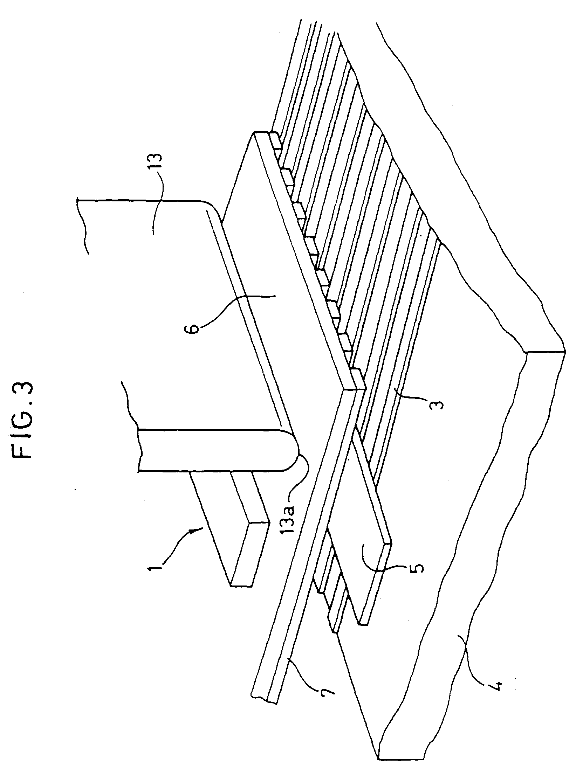

Figure 3 is a perspective view of the junction between an outer lead of an IC part mounted by the electronic part mounting method according to a third embodiment of the present invention and a printed circuit board and of the neighborhood of the junction. Elements with the same functions as those of the above embodiments and conventional elements are given the same numerals, and their description is omitted.

In Figure 3, a numeral 13 indicates a tool which is used when the anisotropic conductive adhesive 5 is hardened by heating and pressurizing the outer lead 6 of the IC part 1, the pressurizing side end 13a of the tool 13 being formed to be semicircularly convex. The semicircular portion of the pressurizing side end 13a of the tool 13 is formed so that its diameter is between 0.1 to 6.0mm.

Since the pressurizing side end 13a is semicircular, using the tool 13 allows the anisotropic conductive adhesive 5 to be easily pushed outward. This, in turn, means that the pressurizing side end 13a, which is semicircularly convex, can more strongly press the outer lead 6 of the IC part 1 against the electrode 3 of the printed circuit board 4, so that the distance between the outer lead 6 of the IC part 1 and the electrode 3 of the printed circuit board 4 is reduced, thus lowering electrical connection resistance. If the semicircular portion of the tool 13 is 0.1mm or less in diameter, the outer lead 6 of the IC part 1 and the printed circuit board 4 may be damaged. On the other hand, if the semicircular portion is 6.0mm or more in diameter, the IC in the IC part 1 may be damaged. Thus forming the pressurizing side end of the tool 13, which is semicircular, to be 0.1 to 6.0mm in diameter prevents the above problem.

### Fourth Embodiment

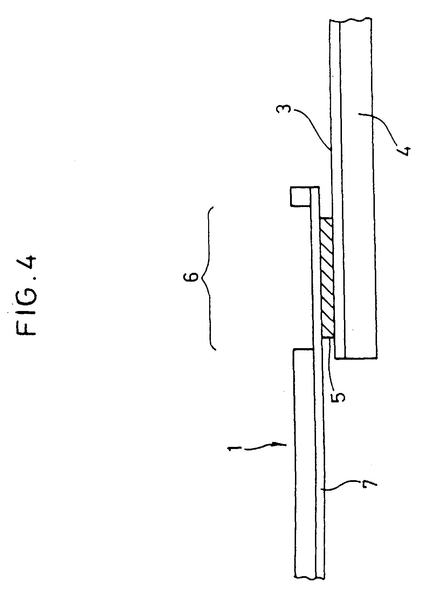

Figure 4 is a cross-sectional view of the junction between an outer lead of an IC part mounted by the electronic part mounting method according to a fourth embodiment of the present invention and a printed circuit board and of the neighborhood of the junction. Elements with the same functions as those of the above embodiments and conventional elements are given the same numerals, and their description is omitted.

As shown in Figure 4, in the fourth embodiment, the outer lead 6 of the IC part 1 to be heated and pressurized is formed with copper foil 7 only.

That is, if outer lead reinforcing resin and copper foil are bonded together with an adhesive as in the conventional case, the adhesive may weaken when heated by a tool, and the adhesion between the reinforcing resin and copper foil deteriorates, so that the IC part may break. According to the fourth embodiment, however, the above problem is eliminated, thus preventing the IC part 1 from breaking, since the outer lead 6 of the IC part 1 to be heated and pressurized is made of the copper foil 7 only.

### Fifth Embodiment

The fifth embodiment includes a tool 11 and the tool 13 (see Figures 1 and 3) for heating and pressurizing which have a thermal conductivity of 4.0 W/m·k or more. That is, if the thermal conductivity of the tools 11 and 13 is less than 4.0 W/m·k, a problem rises of heat not being supplied quickly to the outer lead to be heated and pressurized due to low thermal conductivity. In the fifth embodiment, however, the thermal conductivity of the tools 11 and 13 is so high that heat can quickly be supplied to the outer lead 6 to be heated and pressurized, thus preventing the IC part 1 from deforming due to thermal expansion.

### Sixth Embodiment

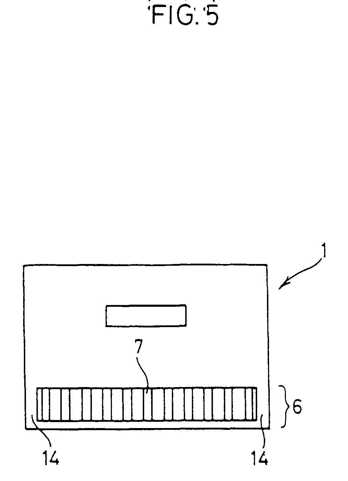

Figure 5 is a front plan view of an IC part mounted by the electronic part mounting method according to a sixth embodiment of the present invention. Elements with the same functions as those of the above embodiments and conventional elements are given the same numerals, and their description is omitted.

In the sixth embodiment, polyimide resin is removed from the outer lead 6 of the IC part 1, with both ends of the outer lead 6 left covered with polyimide resin, and portions 14 free from the copper foil 7 are formed at both ends of the outer lead 6 of the IC part 1 by forming the copper foil 7 on the portion from which polyimide resin has been removed.

According to the sixth embodiment, the outer lead 6 of the IC part 1 is inhibited from expanding due to heat, thus preventing the outer lead 6 from breaking, since the portions 14 free from the copper foil 7 are formed at both ends of the outer lead 6 of the IC part 1.

Examples of the present invention are described below.

### Example 1

Referring now to Figure 1, Example 1 is described.

The IC part 1 (outer lead length: 2mm, lead pitch: 0.48mm) on which a pattern is formed by bonding the copper foil 7 like film and an IC is mounted is installed on a liquid-crystal panel 10. In addition, the anisotropic conductive adhesive 5 (SZF-9003B from Sumitomo Bakelite Co., thickness: 35µmm, width: 1.5mm) was applied to the electrode 3, formed with copper foil (thickness: 35µmm, equivalent to FR4) on the printed circuit board 4, the outer lead 6 of the IC part 1, installed on the liquid-crystal panel 10, was placed on the electrode 3 of the printed circuit board 4, and the outer lead 6 was heated and pressurized (180°C, 40 kg/cm²) by means of the tool 11 (Cr₃C₂ width: 2.5mm, thermal conductivity: 13.8 W/m·k) to harden the anisotropic conductive adhesive 5.

The length of the outer lead 6 of the IC part 1, the material for the printed circuit board 4, the copper foil thickness, the type of anisotropic conductive adhesive 5 and its application thickness and width, and the material for the tool 11 and its width are specified in the above description, but the specified values are only unlimited examples.

### Example 2

The printed circuit board 4 in Example 1 was used after antioxidant 12 (see Figure 2 (b)) is removed from the electrode 3 of the printed circuit board 4 using a cloth moistened with ethanol. Other steps and conditions are the case with Example 1.

### Example 3

The tool 13 whose pressurizing side end 13a is semicircular (diameter: 3mm) was used. Other steps and conditions are the case with Example 1.

### Example 4

The outer lead 6 of the IC part 1 in Example 1 was used after polyimide resin was removed from the outer lead. Other steps and conditions are the case with Example 1.

### Example 5

The material for the tool 11 in Example 1 was changed to ziruconium oxide-niobium carbide (ZrO₂-NbC). Other steps and conditions are the case with Example 1.

### Example 6

The outer lead 6 of the IC part 1 in Example 1 was used after polyimide resin was removed from the outer lead, with both ends (width: 1.0mm) thereof left covered with polyimide resin. The width of both ends of the outer lead 6 of the IC part 1 is not limited. Other steps and conditions are the case with Example 1.

### Comparison Example 1

The electrode 3 of the printed circuit board 4 was used which was formed from copper foil (thickness: 35µmm, equivalent to FR4) and solder-plated (coating thickness: 15µmm). Other steps and conditions are the case with Example 1.

### Comparison Example 2

The IC part 1 on which a pattern was formed by bonding the copper foil 8 like film and an IC was installed was used after polyimide resin was removed from the outer lead 6 (length: 2mm, pitch: 0.48mm) of the IC part, and the outer lead 6 was soldered to the electrode 3 of the printed circuit board 4, using eutectic solder. Other steps and conditions are the case with Example 1.

Fifty samples were made for each of Examples 1 through 6 and Comparison Examples 1 and 2, and the incidence of discontinuity and continuity resistance were determined.

**Table 1**

| Item | Embodiment 1 | Embodiment 2 | Embodiment 3 | Embodiment 4 | Embodiment 5 | Embodiment 6 | Comparative example 1 | Comparative example 2 |
|---|---|---|---|---|---|---|---|---|
| Incidence of discontinuity (%) | 0 | 0 | 0 | 0 | 0 | 0 | 2.5 | 1.0 |
| Continuity resistance (mÙ) | 12 | 10 | 10 | 12 | 12 | 12 | 23 | 15 |

Table 1 shows that Examples 1 through 6 offer satisfactory continuity resistance without undergoing discontinuity and provide highly reliable mounting quality by eliminating quality instability.

As described above, according to the present invention, mounting an electronic part installed on a liquid-crystal panel on a printed circuit board having an electrode formed with copper foil, with anisotropic conductive adhesive between the electronic part and the printed circuit board provides a mounting method that causes no discontinuity and offers low continuity resistance.

## Claims

1. An electronic part mounting method for mounting an electronic part (1) on a printed circuit board (4) by joining an outer lead (6) of the electronic part, such as an IC part bonded to a liquid-crystal panel (10), to the printed circuit board, comprising the steps of:
applying an anisotropic conductive adhesive (5) onto an electrode (3) of the printed circuit board (4), the electrode being formed with copper foil (7);
placing the outer lead (6) of the electronic part (1) on the electrode (3) of the printed circuit board (4); and
hardening said anisotripic conductive adhesive (5) by heating and pressurizing the outer lead (6) of the electronic part placed on the electrode of the printed circuit board, by means of a tool (13).

2. An electronic part mounting method according to Claim 1, wherein antioxidant (12) is removed from the electrode of the printed circuit board, the electrode being formed with copper foil (7), and the anisotropic conductive adhesive (5) is applied directly onto the electrode (3) of the printed circuit board (1).

3. An electronic part mounting method according to Claim 1 or 2, wherein the pressurizing side end (13a) of the tool for heating and pressurizing is semicircularly convex, and the diameter of the semicircle is between 0.1 and 6.0mm.

4. An electronic part mounting method according to any of Claims 1 through 3, wherein the outer lead (6) of the electronic part (1) to be heated and pressurized is formed with copper foil only.

5. An electronic part mounting method according to any of Claims 1 through 4, wherein the tool (11, 13) for heating and pressurizing has a thermal conductivity of 4.0 W/m·k or more.

6. An electronic part mounting method according to any of Claims 1 through 5, wherein copper foil is formed on the portion of the outer lead of the electronic part to be heated and pressurized other than both ends of the outer lead, and portions on which no copper foil is provided are formed at both ends of the outer lead.
